# EUROPEAN PATENT SPECIFICATION

(11) **EP 2 916 188 B1**
(45) Date of publication and mention of the grant of the patent: **20.11.2019**
(21) Application number: 12887505.1
(22) Date of filing: 30.10.2012
(51) Int. Cl.: G05B 19/418, H05K 13/08

(54) **SYSTEM FOR MONITORING PRODUCTION ON COMPONENT MOUNTING LINE**
SYSTEM ZUR PRODUKTIONSÜBERWACHUNG AUF EINER KOMPONENTENMONTAGESTRASSE
SYSTÈME PERMETTANT DE SURVEILLER LA PRODUCTION SUR UNE LIGNE DE MONTAGE DE COMPOSANT

(43) Date of publication of application: 09.09.2015
(73) Proprietor: FUJI Corporation, Chiryu Aichi (JP)
(72) Inventor: KATO, Daisuke, Chiryu Aichi (JP); KAWAI, Takayoshi, Chiryu Aichi (JP); NAITO, Shinji, Chiryu Aichi (JP)
(74) Representative: Grünecker Patent- und Rechtsanwälte PartG mbB
(86) International application number: PCT/JP2012/078013
(87) International publication number: WO 2014/068664

(56) References cited:
- JP-A- 2001 242 926
- JP-A- 2004 260 034
- JP-A- 2006 228 799
- JP-A- 2006 228 799
- JP-A- 2006 339 244
- JP-A- 2006 339 244
- JP-A- 2007 095 761
- JP-A- 2008 197 901
- JP-A- 2008 197 901
- JP-A- 2012 209 300

## Description

### Technical Field

The present invention relates to a production monitoring system of a component mounting line on which a plurality of devices are disposed along a conveyance line of an electronic component mounted board having a mounted electronic component, the plurality of devices performing a plurality of processes for producing the board in an order.

### Background Art

In a component mounting line for producing an electronic component mounted board having a mounted electronic component, a solder printer, an adhesive coating device, an electronic component mounter, a reflow device, and the like are disposed along a conveyance line of the printed circuit board, and a circuit board is conveyed from an upstream side of the conveyance line and passes through each of the devices. Thus, the electronic component mounted board is produced through processes such as printing solder paste on a surface of the printed circuit board, and mounting an electronic component. In such a component mounting line, a visual inspection device is provided in the middle of the component mounting line, a solder paste printed state of a surface of a printed circuit board or a mounted state of an electronic component is captured by using a camera and visual inspection is performed, and when a printing defect or a mounting defect is detected, a printed circuit board having the defect is withdrawn from the component mounting line, as disclosed in PTL 1 (JP-A-2011-119429) or PTL 2 (JP-A-2011-243884) or JP 2006 228799 or JP 2006 339244.

### Citation List

### Patent Literature

PTL 1: JP-A-2011-119429
PTL 2: JP-A-2011-243884

JP 2006 228799

JP 2006 339244

### Summary of Invention

### Technical Problem

In the component mounting line in the related art, a solder paste printed state of a surface of a printed circuit board or a mounted state of an electronic component is captured by using a camera and visual inspection is performed in the middle of the component mounting line. However, by visual inspection, only a visual defect can be detected and it is impossible to detect a non-visual defect. Thus, a defective printed circuit board in which a visual defect is not detected by the visual inspection is conveyed toward a downstream side of a conveyance line and a similar process for a normal printed circuit board is performed. Since a defective printed circuit board is included among electronic component mounted boards produced on the component mounting line, all electronic component mounted boards produced on the component mounting line are finally inspected (for example, a function inspection, a conduction inspection, an X-ray inspection, and the like) by a product inspection device, and a defective printed circuit board is found out and discarded, but an electronic component mounted board continues to be produced on the component mounting line without removal of a defect occurrence cause even after detection of a defect. Accordingly, there is a problem in that a defective printed circuit board wastefully continues to be produced even after detection of a defect and a production yield is degraded.

An object of the present invention is to provide a production monitoring system of a component mounting line that can stop producing a defective printed circuit board and improve a production yield when a defect of an electronic component mounted board produced on the component mounting line is detected.

### Solution to Problem

In order to solve the problem, according to an aspect of the present invention, there is provided a production monitoring system of a component mounting line on which a plurality of devices are disposed along a conveyance line of an electronic component mounted board having a mounted electronic component, the plurality of devices performing a plurality of processes for producing the board in an order. The system includes a product inspection device that inspects the electronic component mounted board produced in the component mounting line, and production monitoring means for specifying a device in which waste occurs and causing the conveyance line to stop conveying a printed circuit board on an upstream side of the specified device when the defect of the electronic component mounted board is detected by the product inspection device.

In this configuration, when a defect of the electronic component mounted board produced on the component mounting line is detected, a device in which waste occurs is specified and the conveyance line on the upstream side of the specified device is caused to stop conveying a printed circuit board. Thus, it is possible to stop production of a defective printed circuit board when a defect is detected and to improve a production yield.

Even though the conveyance line on a downstream side of the device in which waste occurs continues to convey a printed circuit board after the defect is detected, a new defective printed circuit board is not produced. However, the similar process for a normal printed circuit board is performed on the defective printed circuit board, and thus this is a reason of an increase in cost.

As countermeasures for this, when a defect of the electronic component mounted board is detected by the product inspection device, the conveyance line on the downstream side of a device in which waste occurs may be caused to stop conveying a printed circuit board, and, at the same time, an instruction to a worker with display and/or sound may be performed so as to withdraw the printed circuit board on the conveyance line on the downstream side. If done in this manner, it is possible to eliminate that the similar process for a normal printed circuit board is wastefully performed on a defective printed circuit board after a defect is detected, and to reduce production costs.

In this case, withdrawal work completion information input means for inputting information of work completion through an operation of a worker when the worker completes a work of withdrawing a printed circuit board on the conveyance line on the downstream side may be included, and work completion may be confirmed based on input information from the withdrawal work completion information input means.

In addition, a sensor and the like may detect presence or absence of a printed circuit board which is on the conveyance line on the downstream side and it may be automatically determined whether or not a worker completes withdrawal work of the printed circuit board on the conveyance line on the downstream side, based on the detection result.

According to the present invention, an instruction with display and/or sound may be performed so as to remove a defect occurrence cause from a device in which defection occurs. If done in this manner, it is possible to cause a worker to more reliably remove the defect occurrence cause.

In this case, it is confirmed that the defect occurrence cause is removed from the device in which waste occurs, and then production of an electronic component mounted board may be started again. If done in this manner, it is possible to prevent start of production of an electronic component mounted board again in a state where a defect occurrence cause is not removed.

According to another aspect of the present invention, defect occurrence device information input means for inputting information on a device in which defection occurs through an operation of a worker may be included, and the device in which defection occurs may be specified based on input information from the defect occurrence device information input means.

In addition, a relationship of details of a defect which is detected by the product inspection device and a device in which waste occurs is made in advance in a form of a database to be stored in a storage device, and a device in which waste occurs may be automatically specified based on the details of a defect which is detected by the product inspection device with reference to the database.

### Brief Description of Drawings

[Fig. 1] Fig. 1 is a block diagram illustrating a schematic configuration of a production monitoring system of a component mounting line according to an example of the present invention.
[Fig. 2] Fig. 2 is a flowchart illustrating a flow of the first half of processes in a production management program.
[Fig. 3] Fig. 3 is a flowchart illustrating a flow of the second half of processes in the production management program.

### Description of Embodiments

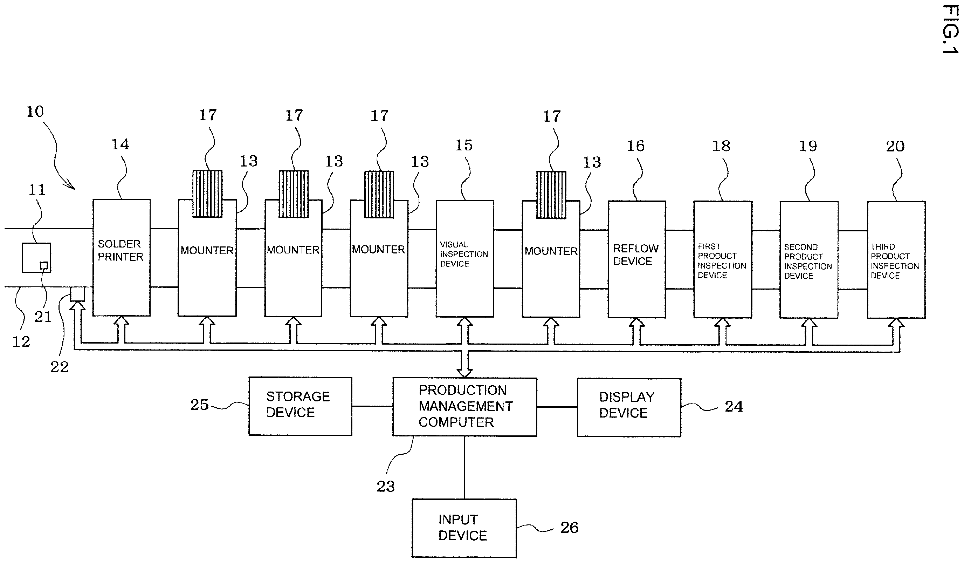

Hereinafter, an example obtained by embodying an embodiment for implementing the present invention will be described. First, a configuration of a component mounting line 10 will be described based on Fig. 1.

A plurality of mounters 13 that mount an electronic component on a circuit board 11 and a machine associated with mounting (device other than the mounters) that performs a work associated with component mounting are arranged over a conveyance line 12 for conveying the circuit board 11. Here, the machine associated with mounting may include a solder printer 14, a visual inspection device 15, a reflow device 16, an adhesive coating device, and the like, for example. The visual inspection device 15 captures a mounted state and the like of an electronic component on the circuit board 11 with a camera (not illustrated) and processes a captured image to perform visual inspection. When a defective printed circuit board is detected by the visual inspection device 15, the defective printed circuit board is discharged by using a defective printed circuit board unloading conveyer (not illustrated) which is provided on an outlet side of the visual inspection device 15.

A feeder 17 for supplying an electronic component is installed on each of the mounters 13. One or a plurality of suction nozzles (not illustrated) is held on a mounting head of each of the mounters 13, and the suction nozzle sucks an electronic component which is supplied from the feeder 17 and mounts the electronic component on the circuit board 11.

First to third product inspection devices 18 to 20 that inspect an electronic component mounted board produced on the component mounting line 10 are arranged on an outlet side (circuit board discharging side) of the conveyance line 12. Each of the product inspection devices 18 to 20 performs, for example, an X-ray inspection, a conduction inspection, a function inspection (electrical characteristics inspection), and the like as product inspection. The total number of the product inspection devices 18 to 20 is not limited to three, and may be two or less or may be four or more.

A printed circuit board ID recording unit 21 (printed circuit board identification information recording unit) is provided on the outside of a component mounted area in an upper surface of the circuit board 11, and the printed circuit board ID recording unit 21 records or stores printed circuit board identification information (transcribed in "printed circuit board ID"). The printed circuit board ID recording unit 21 may record a code such as a barcode and a two-dimensional code and may use an electronic tag (also referred to as an RF tag, a wireless tag, an IC tag, a radio frequency identification tag, and the like) that performs electronic storing, a magnetic tape that performs magnetic recording, or the like.

A reader 22 is provided on an inlet side (circuit board insertion side) of the conveyance line 12 as printed circuit board identification information reading means that reads the printed circuit board ID recorded or stored in the printed circuit board ID recording unit 21.

A production management computer 23 (production monitoring means) that manages and monitors production on the component mounting line 10 causes the reader 22 which is disposed on the inlet side of the conveyance line 12 to read the printed circuit board ID from the printed circuit board ID recording unit 21 of the circuit board 11 which is put onto the conveyance line 12. The production management computer 23 associates mounted component information and the like of the circuit board 11 taken out from the conveyance line 12 with a corresponding printed circuit board ID of the circuit board 11 and stores a result of association in a storage device 24 (storage means). With this, a function of traceability is performed such that when it is revealed that a component, a material, a process, or the like which is used in each device over the component mounting line 10 is poor, the defective printed circuit board can be figured out from the printed circuit board ID, be withdrawn, and the like.

An electronic component mounted board produced on the component mounting line 10 is conveyed to the first to the third product inspection devices 18 to 20 and production inspection (for example, an X-ray inspection, a conduction inspection, a function inspection, and the like) is performed. Information of an inspection result of each of the product inspection devices 18 to 20 is transmitted to the production management computer 23. The production management computer 23 monitors a production circumstance of the component mounting line 10 based on the information of the inspection result received from the product inspection devices 18 to 20, specifies a device in which defection occurs when the defect of an electronic component mounted board is detected by any one of the product inspection devices 18 to 20, and causes the conveyance line 12 on an upstream side of the device to stop conveying a printed circuit board.

At this time, even though the conveyance line 12 on a downstream side of the device in which defection occurs continues to convey a printed circuit board after the defect is detected, a new defective printed circuit board is not produced. However, the similar process for a normal printed circuit board is performed on the defective printed circuit board, and thus this is a reason of an increase in cost.

As countermeasures for this, in this example, the conveyance line 12 on a downstream side of a device in which defection occurs is caused to stop conveying a printed circuit board when the defect of an electronic component mounted board is detected by any one of the product inspection devices 18 to 20, and display is performed on a display device 25 or an instruction to a worker is performed with sound so as to withdraw the printed circuit board on the conveyance line 12 on the downstream side. If done in this manner, it is possible to eliminate that the similar process for a normal printed circuit board is wastefully performed on a defective printed circuit board after a defect is detected, and to reduce production costs. A function of displaying a withdrawal instruction may be provided in each device over the component mounting line 10 or at a predetermined position of the conveyance line 12 other than the display device 25 of the production management computer 23 and may be provided in a portable terminal held by a worker.

Further, in this example, the production management computer 23 includes an input device 26 (withdrawal work completion information input means) that inputs information of work completion to the production management computer 23 through an operation of a worker when the worker completes a work of withdrawing the printed circuit board on the conveyance line 12 on the downstream side, and the work completion is confirmed based on input information from the input device 26. The input device 26 may be configured by a keyboard, a mouse, a touch panel, and the like. A function as the withdrawal work completion information input means may be provided in each device over the component mounting line 10 or at a predetermined position of the conveyance line 12 other than the input device 26 of the production management computer 23, and may be provided in a portable terminal held by a worker.

An optical sensor and the like may detect presence or absence of a printed circuit board which is on the conveyance line 12 on the downstream side and it may be automatically determined whether or not a worker completes withdrawal work of the printed circuit board on the conveyance line 12 on the downstream side, based on a detection result.

In this example, display is performed on the display device 25 (or each device over the component mounting line 10 or a display device provided at a predetermined position of the conveyance line 12) of the production management computer 23 or a portable terminal, or an instruction to a worker is performed with sound so as to remove a defect occurrence cause from a device in which defection occurs. If done in this manner, it is possible to cause a worker to more reliably remove the defect occurrence cause.

In this case, the production management computer 23 confirms that the defect occurrence cause is removed from the device in which defection occurs, and then causes production of an electronic component mounted board to be started again. If done in this manner, it is possible to prevent start of production of an electronic component mounted board again in a state where a defect occurrence cause is not removed. Regarding confirmation of whether or not a restoration work of removing a defect occurrence cause is completed, restoration work completion may be confirmed by a worker operating the input device 26 (or each device over the component mounting line 10 or an input device provided at a predetermined position of the conveyance line 12) of the production management computer 23 or a portable terminal, and inputting information of restoration work completion. In addition, a state change of a device in which defection occurs may be detected by the production management computer 23 and the restoration work completion may be automatically confirmed.

In this example, the input device 26 of the production management computer 23 also functions as defect occurrence device information input means. Thus, a worker operates the input device 26 and inputs information on a device in which defection occurs to the production management computer 23 and the production management computer 23 specifies the device in which defection occurs based on the input information. The function as the defect occurrence device information input means may be provided in each device over the component mounting line 10 or at a predetermined position of the conveyance line 12, and may be provided in a portable terminal held by a worker.

In addition, a relationship of details of a defect which is detected by the product inspection devices 18 to 20 and a device in which defection occurs is made in advance in a form of a database to store the relationship in the storage device 25, and a device in which defection occurs may be automatically specified based on the details of a defect which is detected by the product inspection devices 18 to 20 with reference to the database.

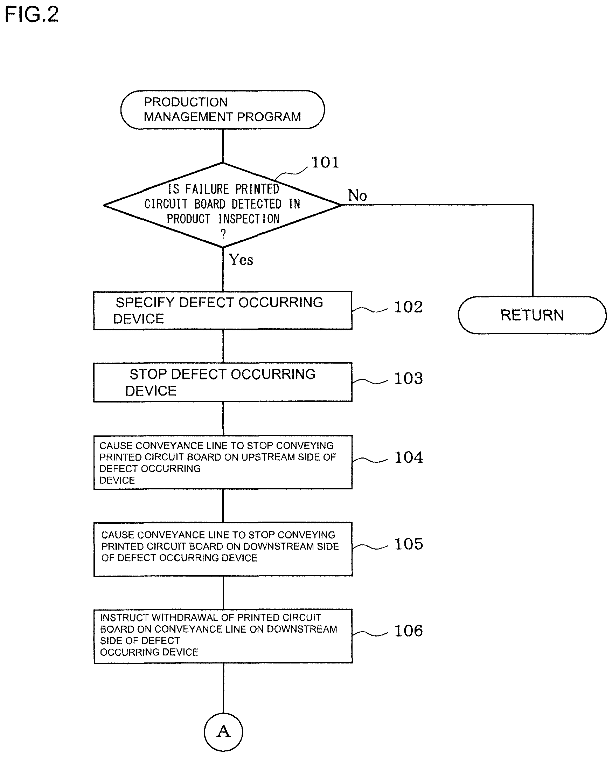

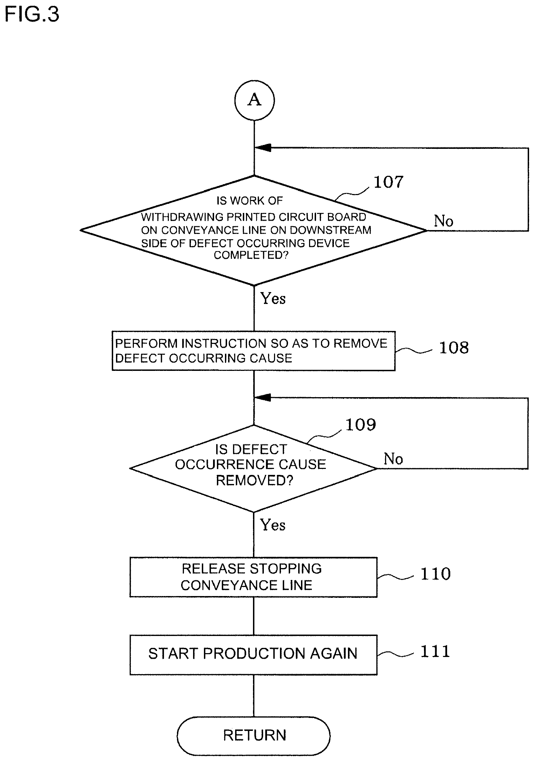

Production management of the above-described component mounting line 10 in this example is performed in accordance with a production management program in Figs. 2 and 3 by the production management computer 23 as follows. The production management program in Figs. 2 and 3 is performed repeatedly at a predetermined interval in the middle of an operation of the component mounting line 10 and functions as production monitoring means described in claims.

If the program is started, first, in Step 101, it is determined whether or not a defective printed circuit board is detected by any one of the first to the third product inspection devices 18 to 20. If the defective printed circuit board is not detected, the following processes are not performed and this program is ended as it is.

In Step 101, if it is determined that the defective printed circuit board is detected, the process proceeds to Step 102 and a device in which defection occurs is specified among the device over the component mounting line 10. At this time, a worker may operate the input device 26, a portable terminal, and the like, and specify a defect occurring device based on information on the defect occurring device which is input to the production management computer 23. In addition, a relationship of details of a defect which is detected by the product inspection devices 18 to 20 and a defect occurring device is made in advance in a form of a database to store the relationship in the storage device 25, and a defect occurring device may be automatically specified based on the details of a defect which is detected by the product inspection devices 18 to 20 with reference to the database. When a defect occurs in some of a plurality of the feeders 17 respectively set on the mounters 13, the feeder 17 of the defect occurring is specified from the plurality of feeders 17.

After the defect occurring device is specified, the process proceeds to Step 103 and the defect occurring device is stopped. Next, in Step 104, the conveyance line 12 is caused to stop conveying a printed circuit board on an upstream side of the defect occurring device. Sequentially, in Step 105, the conveyance line 12 is caused to stop conveying a printed circuit board on a downstream side of the defect occurring device.

Then, the process proceeds to Step 106 and display is performed on the display device 25 or a portable terminal, or an instruction to a worker is performed with sound so as to withdraw the printed circuit board on the conveyance line 12 on the downstream side of the defect occurring device. As in this example, when the circuit board 11 includes the printed circuit board ID recording unit 21 to perform traceability management, a withdrawal instruction for a printed circuit board which is not put on the conveyance line 12 may be output.

Then, the process proceeds to Step 107 in Fig. 3 and it is determined whether or not a work of withdrawing the printed circuit board on the conveyance line 12 on the downstream side of the defect occurring device is completed (whether or not a worker operates the input device 26, a portable terminal, and the like to input information of printed circuit board withdrawal work completion). If a printed circuit board withdrawal work is not completed, the process waits until the printed circuit board withdrawal work is completed (until the information of printed circuit board withdrawal work completion is input) . A printed circuit board ID may be read from the printed circuit board ID recording unit 21 of a withdrawn defective printed circuit board and it may be confirmed whether or not the defective printed circuit board is withdrawn, through the withdrawal instruction.

Then, the process proceeds to Step 108 at a time of completion of the printed circuit board withdrawal work (at a time when the information of printed circuit board withdrawal work completion is input) . Display is performed on the display device 25, a portable terminal, and the like or an instruction to a worker is performed with sound so as to remove a defect occurrence cause from the defect occurring device. Then, the process proceeds to Step 109 and it is determined whether or not the defect occurrence cause is removed (whether or not a worker operates the input device 26, a portable terminal, and the like to input information of restoration work completion) . If a restoration work is not completed, the process waits until the restoration work is completed (until the information of restoration work completion is input).

Then, the process proceeds to Step 110 at a time of completion of the restoration work (at a time when the information of restoration work completion is input), and stopping the conveyance line 12 is released. Next, in Step 111, production of an electronic component mounted board is started again.

According to the above-described example, since when a defect of an electronic component mounted board which is produced on the component mounting line 10 is detected, a device in which defection occurs is specified and the conveyance line 12 is caused to stop conveying a printed circuit board on an upstream side of the device, it is possible to stop production of a defective printed circuit board when a defect is detected and to improve a production yield.

In this example, since when a defect of an electronic component mounted board is detected by the first to the third product inspection devices 18 to 20, the conveyance line 12 is caused to stop conveying a printed circuit board on a downstream side of a device in which defection occurs and an instruction to a worker with a display and/or a sound is performed so as to withdraw the printed circuit board on the conveyance line 12 on the downstream side, it is possible to eliminate that the similar process for a normal printed circuit board is wastefully performed on a defective printed circuit board after a defect is detected, and to reduce production costs.

A configuration of the component mounting line which can apply the present invention is not limited to the configuration in Fig. 1 and the component mounting line may be configured by only a plurality of mounters. The present invention may be variously changed and implemented within a range without departing from the gist, for example, the number of mounters or the type of a machine associated with mounting (device other than the mounters), arrangement of devices may be appropriately changed, or the like.

### Reference Signs List

10...COMPONENT MOUNTING LINE, 11...CIRCUIT BOARD, 12...CONVEYANCE LINE, 13...MOUNTER, 14...SOLDER PRINTER, 15...VISUAL INSPECTION DEVICE, 16...REFLOW DEVICE, 17...FEEDER, 18...FIRST PRODUCT INSPECTION DEVICE, 19...SECOND PRODUCT INSPECTION DEVICE, 20...THIRD PRODUCT INSPECTION DEVICE, 21...PRINTED CIRCUIT BOARD ID RECORDING UNIT (PRINTED CIRCUIT BOARD IDENTIFICATION INFORMATION RECORDING UNIT), 22...READER (PRINTED CIRCUIT BOARD IDENTIFICATION INFORMATION READING MEANS), 23...PRODUCTION MANAGEMENT COMPUTER (PRODUCTION MONITORING MEANS), 24...STORAGE DEVICE (STORAGE MEANS), 25...DISPLAY DEVICE, 26...INPUT DEVICE (WITHDRAWAL WORK COMPLETION INFORMATION INPUT MEANS AND DEFECT OCCURRENCE DEVICE INFORMATION INPUT MEANS)

## Claims

1. A production monitoring system for a component mounting line (10) on which a plurality of devices (13, 14, 15, 16, 17, 18, 19, 20) are disposed along a conveyance line (12) which is suitable for producing an electronic component mounted board (11) having a mounted electronic component, and in which the plurality of devices (13, 14, 15, 16, 17, 18, 19, 20) perform a plurality of processes for producing the board (11) in an order, the system comprising:
a product inspection device (18, 19, 20) that inspects the electronic component mounted board (11) produced in the component mounting line (10); and
production monitoring means (23) for specifying a device in which waste occurs, and stopping the conveyance line (12) conveying a printed circuit board (11) on an upstream side of the specified device when the defect of the electronic component mounted board (11) is detected by the product inspection device (18, 19, 20);
**characterized in that**
the production monitoring means (23) stops the conveyance line (12) conveying a printed circuit board (11) on a downstream side of a device in which waste occurs and performs an instruction to a worker with display and/or sound so as to withdraw the printed circuit board (11) on the conveyance line (12) on the downstream side, when the defect of the electronic component mounted board (11) is detected by the product inspection device (18, 19, 20).

2. The production monitoring system for a component mounting line (10) according to Claim 1, further comprising:
withdrawal work completion information input means (26) for inputting information of work completion through an operation of a worker when the worker completes a work of withdrawing the printed circuit board (11) on the conveyance line (12) on the downstream side,
wherein the production monitoring means (23) confirms work completion based on input information from the withdrawal work completion information input means (26).

3. The production monitoring system for a component mounting line (10) according to any one of Claims 1 to 2, wherein
the production monitoring means (23) performs an instruction to a worker with display and/or sound so as to remove a defect occurrence cause from the device in which waste occurs.

4. The production monitoring system for a component mounting line (10) according to Claim 3, wherein
the production monitoring means (23) confirms removal of the defect occurrence cause from the device in which waste occurs and then starts to produce the electronic component mounted board (11) again.

5. The production monitoring system for a component mounting line (10) according to any one of Claims 1 to 4, further comprising:
defect occurrence device information input means (26) for inputting information on the device in which waste occurs through an operation of a worker,
wherein the production monitoring means (23) specifies the device in which waste occurs based on input information from the defect occurrence device information input means (26).

## Patentansprüche

1. Produktionsüberwachungs-System für eine Bauteil-Montagestraße (10), an der eine Vielzahl von Vorrichtungen (13, 14, 15, 16, 17, 18, 19, 20) entlang einer Förderstrecke (12) angeordnet sind, die zum Herstellen einer mit einem elektronischen Bauteil bestückten Platte (11) geeignet ist, auf der ein elektronisches Bauteil montiert ist, und an der die Vielzahl von Vorrichtungen (13, 14, 15, 16, 17, 18, 19, 20) eine Vielzahl von Prozessen zum Herstellen der Platte (11) in einer Reihenfolge durchführen, wobei das System umfasst:
eine Produkt-Prüfungsvorrichtung (18, 19, 20), die die auf der Bauteil-Montagestraße (10) hergestellte mit einem elektronischen Bauteil bestückte Platte (11) prüft; sowie
eine Produktionsüberwachungs-Einrichtung (23), die eine Vorrichtung bestimmt, an der Ausschuss auftritt, und die Förderstrecke (12) anhält, die eine Leiterplatte (11) an einer von der der bestimmten Vorrichtung stromauf liegenden Seite fördert, wenn der Mangel der mit einem elektronischen Bauteil bestückten Platte (11) von der Produkt-Prüfungsvorrichtung (18, 19, 20) erfasst wird;
**dadurch gekennzeichnet, dass**
die Produktionsüberwachungs-Einrichtung (23) die Förderstrecke (12) anhält, die eine Leiterplatte (11) an einer von der Vorrichtung, an der Ausschuss auftritt, stromab liegenden Seite fördert, und einer Arbeitskraft mittels Anzeige und/oder Ton eine Anweisung dahingehend erteilt, die Leiterplatte (11) auf der Förderstrecke (12) an der stromab liegenden Seite zu entnehmen, wenn der Mangel der mit einem elektronischen Bauteil bestückten Platte (11) durch die Produkt-Prüfungsvorrichtung (18, 19, 20) erfasst wird.

2. Produktionsüberwachungs-System für eine Bauteil-Montagestraße (10) nach Anspruch 1, das des Weiteren umfasst:
eine Einrichtung (26) zum Eingeben von Informationen über Abschluss eines Entnahmevorgangs, über die Informationen über Abschluss eines Vorgangs mittels einer Betätigung durch eine Arbeitskraft eingegeben werden, wenn die Arbeitskraft einen Vorgang zum Entnehmen der Leiterplatte (11) an der Förderstrecke (12) an der stromab liegenden Seite abschließt,
wobei die Produktionsüberwachungs-Einrichtung (23) Abschluss des Vorgangs auf Basis eingegebener Informationen von der Einrichtung (26) zum Eingeben von Informationen über Abschluss eines Entnahmevorgangs prüft.

3. Produktionsüberwachungs-System für eine Bauteil-Montagestraße (10) nach einem der Ansprüche 1 bis 2, wobei
die Produktionsüberwachungs-Einrichtung (23) einer Arbeitskraft mittels Anzeige und/oder Ton eine Anweisung dahingehend erteilt, eine Ursache für das Auftreten eines Mangels an der Vorrichtung zu beseitigen, an der Ausschuss auftritt.

4. Produktionsüberwachungs-System für eine Bauteil-Montagestraße (10) nach Anspruch 3, wobei
die Produktionsüberwachungs-Einrichtung (23) Beseitigung der Ursache für das Auftreten eines Mangels an der Vorrichtung prüft, an der Ausschuss auftritt, und dann wieder beginnt, die mit einem elektronischen Bauteil bestückte Platte (11) herzustellen.

5. Produktionsüberwachungs-System für eine Bauteil-Montagestraße (10) nach einem der Ansprüche 1 bis 4, das des Weiteren umfasst:
eine Einrichtung (26) zum Eingeben von Informationen über die Vorrichtung, an der Ausschluss auftritt, mittels einer Betätigung durch eine Arbeitskraft Informationen über die Vorrichtung eingegeben werden, an der Ausschuss auftritt,
wobei die Produktionsüberwachungs-Einrichtung (23) die Vorrichtung, an der Ausschuss auftritt, auf Basis eingegebener Informationen von der Einrichtung (26) zum Eingeben von Informationen über die Vorrichtung bestimmt, an der Ausschluss auftritt.

## Revendications

1. Système de surveillance de production pour une ligne de montage de composants (10) sur laquelle une pluralité de dispositifs (13, 14, 15, 16, 17, 18, 19, 20) sont disposés le long d'une ligne de transport (12) qui est adaptée à la production d'une carte à composant électronique monté (11) ayant un composant électronique monté, et dans lequel la pluralité de dispositifs (13, 14, 15, 16, 17, 18, 19, 20) effectuent une pluralité de processus pour produire la carte (11) dans un ordre, le système comprenant :
un dispositif d'inspection de produit (18, 19, 20) qui inspecte la carte à composant électronique monté (11) produite dans la ligne de montage de composants (10) ; et
des moyens de surveillance de production (23) pour spécifier un dispositif dans lequel survient un rebu, et pour arrêter la ligne de transport (12) transportant une carte de circuit imprimé (11) sur un côté amont du dispositif spécifié lorsque le défaut de la carte à composant électronique monté (11) est détecté par le dispositif de d'inspection de produit (18, 19, 20) ;
**caractérisé en ce que**
les moyens de surveillance de production (23) arrêtent la ligne de transport (12) transportant une carte de circuit imprimé (11) sur un côté aval d'un dispositif dans lequel survient un rebu et donnent une instruction à un ouvrier d'afficher et/ou émettre un son de manière à retirer la carte de circuit imprimé (11) sur la ligne de transport (12) sur le côté côté aval, lorsque le défaut de la carte à composant électronique monté (11) est détecté par le dispositif d'inspection de produit (18, 19, 20).

2. Système de surveillance de production pour une ligne de montage de composants (10) selon la revendication 1, comprenant en outre :
des moyens d'entrée d'informations d'achèvement de travail de retrait (26) pour entrer des informations d'achèvement de travail par le biais d'une opération d'un ouvrier lorsque l'ouvrier achève un travail de retrait de la carte de circuit imprimé (11) sur la ligne de transport (12) sur le côté aval,
dans lequel les moyens de surveillance de production (23) confirment un achèvement de travail sur la base d'informations d'entrée provenant des moyens d'entrée d'informations d'achèvement de travail de retrait (26).

3. Système de surveillance de production pour une ligne de montage de composants (10) selon l'une quelconque des revendications 1 à 2, dans lequel
les moyens de surveillance de production (23) donnent une instruction à un ouvrier d'afficher et/ou émettre un son afin de retirer une cause d'apparition de défaut depuis le dispositif dans lequel survient un rebu.

4. Système de surveillance de production pour une ligne de montage de composants (10) selon la revendication 3, dans lequel
les moyens de surveillance de production (23) confirment le retrait de la cause d'apparition de défaut depuis le dispositif dans lequel survient un rebu, et recommence ensuite à produire la carte à composant électronique monté (11).

5. Système de surveillance de production pour une ligne de montage de composants (10) selon l'une quelconque des revendications 1 à 4, comprenant en outre :
des moyens d'entrée d'informations de dispositif à apparition de défaut (26) pour entrer des informations concernant le dispositif dans lequel survient un rebu par le biais d'une opération d'un ouvrier,
dans lequel les moyens de surveillance de production (23) spécifient le dispositif dans lequel survient un rebu sur la base d'informations d'entrée en provenance des moyens d'entrée d'informations de dispositif à apparition de défaut (26).
